# EUROPEAN PATENT APPLICATION

(11) **EP 4 761 116 A1**
(43) Date of publication of application: **17.06.2026**
(21) Application number: 24219074.2
(22) Date of filing: 11.12.2024
(51) Int. Cl.: H03L 7/16

(54) **METHOD FOR CALCULATING PHASE INFORMATION OF A LOCAL OSCILLATOR SIGNAL**

(71) Applicant: u-blox AG, 8800 Thalwil (CH)
(72) Inventor: Beamish, Norman, 8800 Thalwil (CH)
(74) Representative: Epping - Hermann - Fischer

(57) **Abstract**

A method for calculating phase information of a local oscillator, LO, signal is provide. The LO signal is generated by a PLL from a reference clock and the LO signal is used in a RF frontend for down-converting a radio signal received by the RF frontend. The method comprises adding a harmonic derived from the reference clock to an input of the RF frontend and down-converting the harmonic using the LO signal; measuring a phase of the down-converted harmonic before a PLL event; measuring the phase of the down-converted harmonic after the PLL event; and calculating the phase information of the LO signal based on the phases measured before and after the PLL event.

## Description

### TECHNICAL FIELD

This disclosure relates to a method for calculating phase information of a local oscillator signal. The disclosure further relates to a control unit and a receiver.

### BACKGROUND ART

Radio signals, also known as radio frequency, RF, signals, are employed in communication systems such as a Global Navigation Satellite System, GNSS, system, a cellular system, etc. In a receiver for receiving radio signals, a local oscillator, LO, signal is generated and has a frequency of a carrier signal for down-converting radio signals using the carrier signal. Typically, a LO signal is generated by a phase-locked loop, PLL, circuit.

For a coherent reception of radio signals, the receiver may observe phase information of the LO signal which reflects phase information of the carrier signal. The phase information of the LO signal is used in the receiver for processing the received signals. However, operation of the PLL may be interrupted during the reception, e.g., the PLL is reset due to a failure or is reconfigured by a user. The LO signal from the PLL is thus interrupted. The observation of phases is no longer continuous, and the phase information is no longer related before and after the interruption. The coherent reception may be no longer available. Operation of the receiver may be degraded. It is thus desirable to preserve phase information under such situations.

In conventional receivers such situations are not well addressed.

### SUMMARY OF INVENTION

An objective to be achieved is to provide an improved concept for calculating phase information of a local oscillator signal.

This objective is achieved with the subject-matter of the independent claims. Embodiments and developments derive from the dependent claims.

According to the present disclosure, a receiver receives a radio signal at a carrier frequency. A LO signal is generated by a PLL from a reference clock and the LO signal is used in a RF, frontend in the receiver for down-converting the radio signal from the carrier frequency. The receiver observes phase information for the carrier signal by measuring phases of signals down-converted by the LO signal. A PLL event may occur during the reception.

The improved concept is based on the idea that a harmonic of the reference clock is added in the receiving chain to be down-converted using the LO signal, and phases of the down-converted harmonic are measured before and after the PLL event. Phase information of the LO signal is calculated based on the phases of the down-converted harmonic measured before and after the PLL event.

According to the improved concept, the harmonic down-converted using the LO signal is used as a beacon which remains constant in frequency and changes in phase before and after the PLL event. The changes in phase of the beacon reflect an actual change of phases of the LO signal due to the PLL event. Phase information of the LO signal is thus calculated based on the phases of the beacon measured before and after the PLL event. A relationship between the LO phases before and after the PLL event can be determined and a correlation in the LO phases can be established. Carrier phase information is thus preserved for ensuring a coherent reception of radio signals. Performance of the receiver is improved.

The improved concept can be particularly applied to GNSS receivers for preserving phase information and improving a coherent reception of GNSS signals.

According to the improved concept, the present disclosure provides a method for calculating phase information of a LO signal. The LO signal is generated by a PLL from a reference clock and the LO signal is used in a RF frontend for down-converting a radio signal received by the RF frontend. The method comprises adding a harmonic derived from the reference clock to an input of the RF frontend and down-converting the harmonic using the LO signal; measuring a phase of the down-converted harmonic before a PLL event; measuring the phase of the down-converted harmonic after the PLL event; and calculating the phase information of the LO signal based on the phases measured before and after the PLL event. The harmonic to be added in the RF frontend can be regarded as a primary beacon signal, and the down-converted harmonic can be regarded as a secondary beacon signal. With the down-conversion operation using the LO signal, the secondary beacon signal remains constant in frequency and changes in phase before and after the PLL event.

Particularly, the harmonic may be down-converted using the LO signal or a secondary LO signal derived from the LO signal. The harmonic added in the RF fronted may pass through a primary receiving chain which receives the radio signal or pass through a parallel receiving chain. A secondary LO signal may be used which can be the same as the LO signal for receiving the radio signal or may be a LO signal derived from that LO signal. When the harmonic is added in the RF frontend through the parallel receiving chain, the harmonic is down-converted using the secondary LO signal and the phases are measured before and after the PLL event upon the harmonic down-converted using the secondary LO signal.

In an example implementation, the calculated phase information of the LO signal comprises a phase difference between the phases measured before and after the PLL event. The change of phases of the LO signal can be thus calculated to establish a correlation in phase of the LO signal when the LO signal is interrupted due to the PLL event.

In some implementations, the PLL event is an interruption in the PLL's operation. The interruption may be a reset, a configuration or a reconfiguration of the PLL by a user. For example, a user needs to control the PLL in the receiver for receiving a different signal at a different frequency, or for operating in a different GNSS system. The interruption may also be a spontaneous or an unexpected restart of the PLL due to an operation failure. In general, any kind of PLL event that causes an interruption in the PLL's operation leads to an interruption of the LO signal output by the PLL, and is addressed by the method for calculating the phase information of the LO signal.

In some implementations, the method further comprises, before the PLL event, monitoring stability of the PLL. For example, monitoring stability of the PLL may comprise monitoring at least one of: a temperature of the PLL, an operation time of the PLL, and a control voltage of the PLL. As a PLL typically operates over a limited range of temperatures, operation time and control voltages, operating outside such ranges may cause the PLL operation unreliable and a reset or a restart of the PLL may be required, which leads to an interruption of the PLL's operation. By monitoring the stability of the PLL, a PLL event such as a reset can be determined, and the calculation of the LO phases can be performed according to the method.

In some implementations, adding the harmonic to the input of the RF frontend further comprises determining the harmonic from a plurality of harmonics of the reference clock or of a clock deterministically derived from the reference clock. For example, the harmonic is receivable by the RF frontend using the LO signal. For example, the RF frontend uses a range of frequencies to receive radio signals with the LO signal. The frequency of the determined harmonic is in that frequency range and is thus receivable by the RF frontend. It is thus able to use the determined harmonic as a primary beacon signal and the down-converted harmonic as a secondary beacon signal in the receiving chain for calculating the phase information of the LO signal.

In some implementations, adding the harmonic to the input of the RF frontend further comprises adjusting an amplitude of the harmonic. For example, the amplitude of the harmonic can be reduced before adding to the input of the RF frontend. An interference for receiving the radio signal can be reduced.

In some implementations, the method further comprises, after calculating the phase information of the LO signal, providing the phase information to a baseband processor of the radio signal. The baseband processor uses the phase information for a coherent reception of the radio signal and thus improves the processing of the radio signal.

The present disclosure further provides a control unit for calculating phase information of a LO signal. The LO signal is generated by a PLL from a reference clock and the LO signal is used in a RF frontend for down-converting a radio signal received by the RF frontend. The control unit is configured to control an adder circuit to add a harmonic derived from the reference clock to an input of the RF frontend, the harmonic to be down-converted using the LO signal; before a PLL event, measure a phase of the down-converted; after the PLL event, measure the phase of the down-converted harmonics; and calculate the phase information of the LO signal based on the phases measured before and after the configuring.

In some implementations, the calculated phase information of the LO signal comprises a phase difference between the phases measured before and after the PLL event.

In some implementations, the PLL event is an interruption in the PLL's operation.

In some implementations, the control unit is further configured to control a monitor circuit to monitor stability of the PLL.

In some implementations, the control unit is further configured to determine the harmonic from a plurality of harmonics of the reference clock or of a clock deterministically derived from the reference clock. For example, the harmonic is receivable by the RF frontend using the LO signal.

In some implementations, the control unit is further configured to control a buffer circuit to adjust an amplitude of the harmonic to be added to the RF frontend.

Further implementations of the control unit become readily apparent from the various implementations described above in conjunction with the method.

The present disclosure further provides a receiver. The receiver comprises a control unit according to one of the implementations described above.

Further implementations of the receiver become readily apparent from the various implementations described above in conjunction with the method and the control unit.

According to one embodiment of the improved concept, a computer program comprises instructions that may be stored in a preferably non-transitory computer-readable storage medium, when the instructions are executed on one or more processors of a terminal device, the instructions enabling the one or more processors to execute a method according to one of the implementations described above.

### BRIEF DESCRIPTION OF DRAWINGS

The improved concept will be explained in more detail in the following with the aid of the drawings.

In the drawings:
- Figure 1: shows a flowchart of a method for calculating phase information of a LO signal;
- Figure 2: shows a flowchart of an example embodiment of the method;
- Figure 3: shows an example implementation of a receiver; and
- Figure 4: shows another example implementation of a receiver.

### DETAILED DESCRIPTION

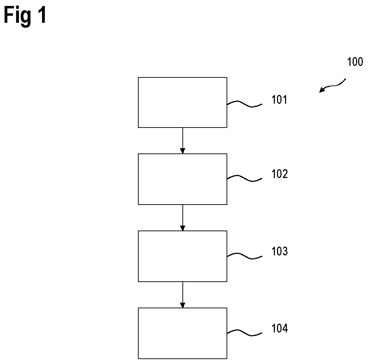

Figure 1 shows a flow diagram of a method 100 for calculating phase information of a LO signal.

Method 100 may be performed by a receiver. The receiver is able to receive radio signals, such as GNSS signals, cellular signals, etc. Method 100 can be applied to any receiver that receives radio signals using LO signals.

Method 100 may be performed by one or more units in the receiver. For example, method 100 may be controlled and performed by a control unit in a receiver.

A receiver for receiving radio signals typically uses a PLL and a reference clock for generating a LO signal. A reference clock can be generated by a reference clock generator. Any kind of PLL and reference clock can be used for generating a LO signal. A radio signal is received by an antenna or an antenna array of the receiver and input to a RF frontend of the receiver to be processed in a receiving chain. For example, in the receiving chain, the radio signal is down-converted from its carrier frequency to an intermediate frequency or a baseband frequency by using the LO signal and may be converted to a digital signal for further digital processing.

In some implementations, method 100 is performed by a GNSS receiver that is able to operate with various GNSS systems, such as GPS, GLONASS, Galileo, and BeiDou, etc. Specifically, method 100 may be controlled and performed by a control unit in a GNSS receiver. A GNSS receiver preserves phase information by using method 100 for a coherent reception of GNSS signals.

In step 101 of method 100, a harmonic derived from the reference clock is added to an input of the RF frontend. The control unit in the receiver may determine to add a harmonic and control an adder circuit or a coupler circuit in the receiver to perform the adding. By adding the harmonic in the input of the RF frontend, the harmonic is down-converted using the LO signal.

In some implementations, for adding the harmonic, the harmonic is inserted in the receiving chain of receiving the radio signal and will be processed together with a received radio signal.

In some further implementations, the receiver may include a parallel receiving chain. The receiving chain and the LO signal for receiving the radio signal can be regarded as a primary receiving chain and a primary LO signal; the parallel receiving chain may be regarded as a secondary receiving chain and uses a secondary LO signal. The parallel receiving chain may not be used to receive the radio signal. The secondary LO signal may be the same as the primary LO signal or may be a LO signal derived from the primary LO signal. In either way, the secondary LO signal undergoes the same impact in phase from a PLL event.

In such implementations, the harmonic can be added to the secondary receiving chain and is not added to the primary receiving chain. By adding the harmonic in the input of the RF frontend through the secondary receiving chain, the harmonic is down-converted using the secondary LO signal. In this way, the primary receiving chain does not require modification for adding a harmonic and avoids impact of involving a harmonic when receiving the radio signal. Normal operations in the primary receiving chain can be maintained.

The harmonic to be added is derived from the reference clock. Harmonics have frequencies that are integer multiples of the reference clock's frequency. In some implementations, the harmonic to be added is a harmonic of the reference clock. In some other implementations, the harmonic to be added may be a harmonic of a clock deterministically derived from the reference clock. A deterministically derived clock has a constant frequency derived from a constant reference clock. A harmonic of such a derived clock has a constant frequency and can be thus used as a beacon to be added to the RF frontend.

To determine a harmonic to be added to the RF frontend, one of the harmonics of the reference clock or of a derived clock is selected, if that harmonic can be received in the RF frontend using the same LO signal for receiving the radio signal. For example, a RF frontend operates in a frequency band for receiving a radio signal and uses a LO signal for the reception; a harmonic is selected if it can be received in the RF frontend with the same LO signal.

In some implementations, step 101 of adding the harmonic is performed, e.g. only performed, when a PLL event is determined to occur. For example, a reset of the PLL is determined to be carried out and a harmonic is added to the RF frontend only before the reset to be carried out.

In some implementations, step 101 of adding the harmonic may be performed at any time and the harmonic remains added in the RF frontend. For example, the harmonic may be added before any PLL event is determined to occur and remain added at any time when a PLL event occurs. The harmonic may be added to and remain added in a secondary receiving chain as described above.

In some implementations, step 101 may further include dividing the reference clock or the deterministically derived clock to obtain harmonics in finer frequencies. The reference clock or the deterministically derived clock may be divided by a factor of N, where N is an integer greater than 0. The harmonic to be added to the RF frontend is selected from the harmonics of divided clocks. The control unit may determine to divide and control a divider in the receiver to perform the dividing.

In some implementations, step 101 may further include adjusting the amplitude of the harmonic to be added to the RF frontend. For example, the amplitude of the harmonic may be reduced before adding to the RF frontend. The control unit may determine to adjust and control a buffer circuit in the receiver to perform the adjustment.

In step 102 of method 100, the phase of the added harmonic after down-conversion, i.e., the phase of the down-converted harmonic, is measured before a PLL event.

The phase of the added harmonic is measured in the receiving chain after the LO signal is applied for down-conversion. For example, the phase of the down-converted harmonic may be measured in a digital processing part in the receiving chain. The control unit may determine to measure, perform the measurement or control a measurement unit in the receiver to perform the measurement. The measurement result may be stored in the receiver for further use.

A PLL event is any event that has impact on phases of the LO signal output by the PLL. The control unit may identify a PLL event and determine to measure before the PLL event.

A PLL event may be an interruption in the operation of the PLL. The interruption may be a reset, a configuration or a reconfiguration of the PLL by a user. For example, a user needs to control the PLL in the receiver for receiving a different signal at a different frequency, or for operating in a different GNSS system. The interruption may also be a spontaneous reset or an unexpected restart of the PLL due to an operation failure. For example, an instability or an operation failure may be determined by the receiver and a reset of the PLL has to be performed.

In some implementations, the operating status of the PLL may be monitored in the receiver, e.g., by a monitor in the receiver. Stability of the PLL can be monitored. For example, at least one of a temperature of the PLL, an operation time of the PLL, and a control voltage of the PLL may be monitored. An instability or an operation failure may be determined and a reset of the PLL is determined to be performed, e.g., by the control unit. As described in step 101, a harmonic has been added in the RF frontend or is added when the reset is determined. In step 102, the phase of the down-converted harmonic is measured before the reset is performed.

In step 103 of method 100, the phase of the down-converted harmonic is measured after the PLL event. The measurement is performed in the same way as in step 102. The control unit may determine to measure after the PLL event. The measurement result may be stored in the receiver for further use.

Between steps 102 and 103, the PLL event may occur, which impacts the LO signal output by the PLL. For example, between steps 102 and 103, an interruption of the PLL occurs, such as a reset or a reconfiguration of the PLL.

In step 104 of method 100, phase information of the LO signal based on the phases measured before and after the PLL event is calculated. The control unit may perform the calculation.

The phase information of the LO signal may include a phase difference between the phases measured before and after the PLL event in steps 102 and 103. The phase difference can be in a range between 0 and 360 degrees.

The phase information may be further provided to further parts in the receiving chain. For example, the phase information may be provided and used for baseband processing, e.g., in a baseband processor.

Method 100 can be performed repeatedly at each time when a PLL event occurs. For example, method 100 may be repeated by starting from step 101, so that a harmonic is added before each time when a PLL event occurs. Method 100 may be repeated by starting from step 102 when a harmonic has been added and remains added in the RF frontend, so that measurements are performed before and after each PLL event.

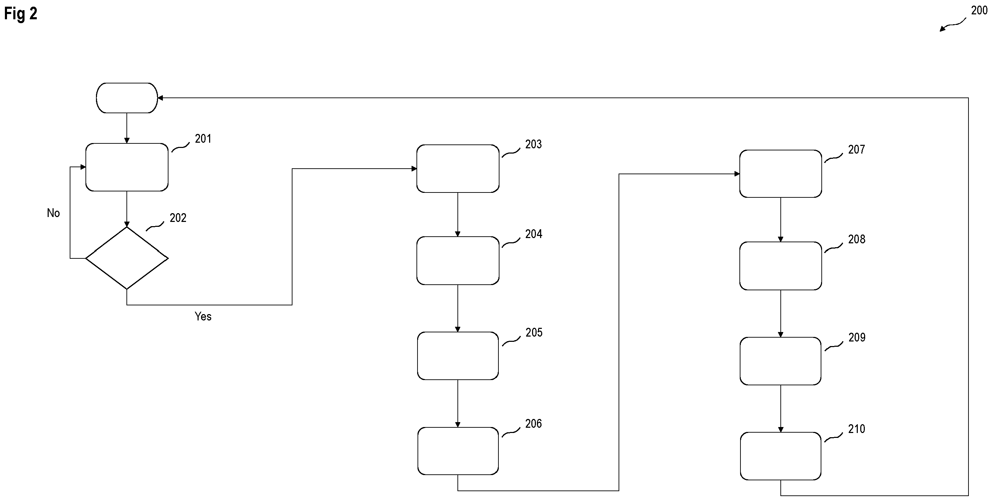

Figure 2 shows a flowchart of an example embodiment 200 of method 100. Embodiment 200 may be performed by a control unit in a receiver. The receiver can be a receiver applied in method 100, which comprises a RF frontend for receiving radio signals, a PLL and a reference clock generator.

In step 201, the control unit controls a monitor to monitor the PLL. The monitor may monitor the operation status of the PLL as described in method 100.

In step 202, the control unit determines whether the PLL operates stably. If no instability is determined, the control unit keeps monitoring. If an instability of the PLL is determined, the control unit determines that a reset of the PLL needs to be performed and goes to step 203 to start preserving phase information of the LO signal.

In step 203, the control unit selects a harmonic of the refence clock used by the PLL or a deterministically derived clock. The control unit may control a divider in the receiver to divide the refence clock or the derived clock and selects a harmonic afterwards. The control unit may further control a buffer circuit in the receiver to reduce an amplitude of the harmonic.

In step 204, the control unit controls an adder circuit or a coupler circuit in the receiver to add the harmonic to an input of the RF frontend.

In step 205, the control unit measures a phase of the down-converted harmonic after the LO signal is applied.

In step 206, the control unit stores the measured phase.

In step 207, the control unit resets the PLL.

In step 208, the control unit measures a phase of the down-converted harmonic after the LO signal is applied.

In step 209, the control unit compares the stored phase in step 206 and the measured phase in step 208.

In step 210, the control unit calculates a change of phases of the LO signal based on the comparison in step 209. Phase information of the LO signal is preserved during the PLL event.

After step 210, the control unit may continue monitoring the PLL for calculating the LO phase information at each PLL event.

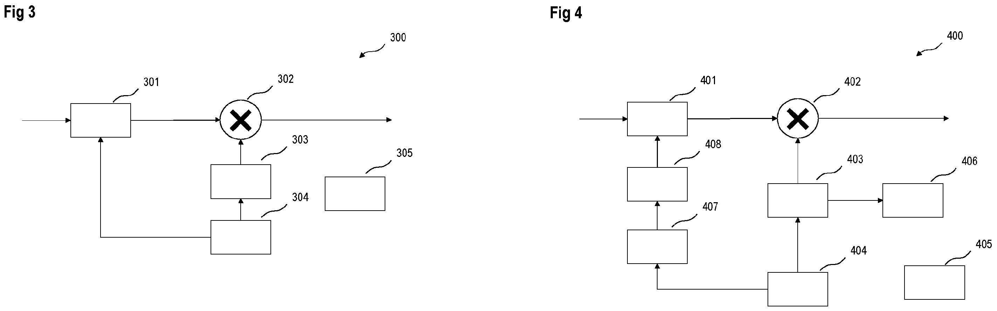

Figure 3 shows an example implementation of a receiver 300. Receiver 300 may be configured to carry out various implementations of method 100 and embodiment 200 as described above.

Figure 3 shows part of a RF frontend of receiver 300. Receiver 300 may be a GNSS receiver for receiving GNSS signals for various GNSS systems, such as GPS, GLONASS, Galileo, and BeiDou, etc.

As shown in Figure 3, receiver 300 includes a PLL 303 and a reference clock generator 304 being the basis for PLL 303 to generate a LO signal for down-converting a radio signal by a mixer 302. Receiver 300 further includes an adder circuit or a coupler circuit 301 for adding a harmonic to the receiving chain. As shown in Figure 3, a harmonic is added by coupler circuit 301 before the input of mixer 302. The harmonic is down-converted by the LO signal via the mixer 302.

Receiver 300 may further include a parallel receiving chain as described in the method above (not shown in Figure 3). The parallel receiving chain includes a secondary LO signal and a secondary mixer. The harmonic is put through the parallel receiving chain and down-converted using the secondary LO signal by the secondary mixer.

Receiver 300 further includes a control unit 305. Control unit 305 may be configured to carry out various implementations of method 100 and embodiment 200 as described above. Control unit 305 may be implemented in a digital processing part in receiver 300.

For example, control unit 305 may be configured to determine a PLL event. Control unit 305 may be configured to select a harmonic of the reference clock generated by reference clock generator 304 or a derived clock (not shown in the figure) and control coupler circuit 301 to add the harmonic. Control unit 305 may be configured to measure a phase of the down-converted harmonic before the PLL event. Control unit 305 may be configured to measure a phase of the down-converted harmonic after the PLL event. Control unit 305 may be further configured to carry out the PLL event between the measurements.

Units 301-305 may be implemented in separate modules. Units 301-305 may be implemented in a same chip.

Further implementations of the control unit 305 and the receiver 300 become readily apparent from the various implementations described above in conjunction with method 100 and embodiment 200.

Figure 4 shows another example implementation of a receiver 400. Receiver 400 may be configured to carry out various implementations of method 100 and embodiment 200 as described above.

Figure 4 shows part of a RF frontend of receiver 400. Similar as in receiver 300, receiver 400 includes an adder or a coupler circuit 401, a mixer 402, a PLL 403, a reference clock generator 404 and a control unit 405.

In addition to receiver 300, receiver 400 further includes a monitor 406 for monitoring operation status of PLL 403. Receiver 400 further includes a divider 407 for dividing the reference clock generated by reference clock generator 404. Receiver 400 further includes a buffer circuit 408 for adjusting amplitude of a harmonic.

In addition to receiver 300, control unit 405 may be further configured to control monitor 406 to monitor PLL 403. Control unit 405 may be further configured to control divider 407 to perform dividing. Control unit 405 may be further configured to control buffer circuit 408 to perform an adjustment.

Units 401-408 may be implemented in separate modules. Units 401-408 may be implemented in a same chip.

Further implementations of the control unit 405 and the receiver 400 become readily apparent from the various implementations described above in conjunction with method 100 and embodiment 200.

Hence, with the various implementations described above for calculating phase information of a LO signal, carrier phase information can be preserved under various PLL interruptions. A coherent reception of radio signals can be maintained at a receiver. Performance of the receiver can be improved.

Various embodiments of the improved concept for calculating phase information of a LO signal can be implemented in the form of logic in software or hardware or a combination of both. The logic may be stored in a computer readable or machine-readable storage medium as a set of instructions adapted to direct one or more processors of a computer system or a terminal device to perform a set of steps disclosed in embodiments of the improved concept. The logic may form part of a computer program product adapted to direct an information-processing device to automatically perform a set of steps disclosed in embodiments of the improved concept.

The specification and drawings are, accordingly, to be regarded in an illustrative rather than a restrictive sense. However, it will be evident that various modifications and changes may be made thereunto without departing from the scope of the invention as set forth in the claims.

### LIST OF REFERENCE SIGNS

- 100, 200: methods
- 101-104, 201-210: steps
- 300, 400: receivers
- 301-305, 401-408: units

## Claims

1. A method for calculating phase information of a local oscillator, LO, signal, wherein the LO signal is generated by a phase-locked loop, PLL, from a reference clock and the LO signal is used in a radio frequency, RF, frontend for down-converting a radio signal received by the RF frontend, the method comprising:
- adding a harmonic derived from the reference clock to an input of the RF frontend and down-converting the harmonic using the LO signal;
- measuring a phase of the down-converted harmonic before a PLL event;
- measuring the phase of the down-converted harmonic after the PLL event; and
- calculating the phase information of the LO signal based on the phases measured before and after the PLL event.

2. The method according to claim 1, wherein the calculated phase information of the LO signal comprises a phase difference between the phases measured before and after the PLL event.

3. The method according to claim 1 or 2, wherein the PLL event is an interruption in the PLL's operation.

4. The method according to any one of claims 1 to 3, wherein the method further comprises, before the PLL event, monitoring stability of the PLL.

5. The method according to claim 4, wherein monitoring stability of the PLL comprises monitoring at least one of: a temperature of the PLL, an operation time of the PLL, and a control voltage of the PLL.

6. The method according to any one of claims 1 to 5, wherein adding the harmonic to the input of the RF frontend further comprises determining the harmonic from a plurality of harmonics of the reference clock or of a clock deterministically derived from the reference clock.

7. The method according to any one of claims 1 to 6, wherein adding the harmonic to the input of the RF frontend further comprises adjusting an amplitude of the harmonic.

8. The method according to any one of claims 1 to 7, wherein the method further comprises, after calculating the phase information of the LO signal, providing the phase information to a baseband processor of the radio signal.

9. A control unit for calculating phase information of a local oscillator, LO, signal, wherein the LO signal is generated by a phase-locked loop, PLL, from a reference clock and the LO signal is used in a radio frequency, RF, frontend for down-converting a radio signal received by the RF frontend, and the control unit is configured to:
- control an adder circuit to add a harmonic derived from the reference clock to an input of the RF frontend, the harmonic to be down-converted using the LO signal;
- before a PLL event, measure a phase of the down-converted harmonic;
- after the PLL event, measure the phase of the down-converted harmonic; and
- calculate the phase information of the LO signal based on the phases measured before and after the PLL event.

10. The control unit according to claim 9, wherein the calculated phase information of the LO signal comprises a phase difference between the phases measured before and after the PLL event.

11. The control unit according to claim 9 or 10, wherein the PLL event is an interruption in the PLL's operation.

12. The control unit according to any one of claim 9 to 11, further configured to control a monitor circuit to monitor stability of the PLL.

13. The control unit according to any one of claims 9 to 12, further configured to determine the harmonic from a plurality of harmonics of the reference clock or of a clock deterministically derived from the reference clock.

14. The control unit according to any one of claims 9 to 13, further configured to control a buffer circuit to adjust an amplitude of the harmonic to be added to the RF frontend.

15. A receiver comprising the control unit according to one of claims 9 to 14, a phase-locked loop, a reference clock, a radio frequency frontend, and an adder circuit to add a harmonic of the reference clock to an input of the radio frequency frontend.
